Europäisches Patentamt

European Patent Office

Office européen des brevets

(19)

(11) Publication number: **0 138 399**
**A1**

## (12) EUROPEAN PATENT APPLICATION

(21) Application number: **84306320.7**

(22) Date of filing: **14.09.84**

(51) Int. Cl.⁴: **G 01 R 13/26**

(30) Priority: **16.09.83 US 533386**

(43) Date of publication of application: **24.04.85**
**Bulletin 85/17**

(84) Designated Contracting States: **DE FR GB NL**

(71) Applicant: **TEKTRONIX, INC., Tektronix Industrial Park
D/S Y3-121 4900 S.W. Griffith Drive P.O. Box 500,
Beaverton Oregon 97077 (US)**

(72) Inventor: **Baker, Daniel G., 6982 S.W. 184th, Aloha
Oregon 97005 (US)**
Inventor: **Ainsworth, Kenneth M., 20587 Shaniko Lane,
Bend Oregon 97701 (US)**

(74) Representative: **Baillie, Iain Cameron et al, c/o Ladas &
Parry Isartorplatz 5, D-8000 München 2 (DE)**

(54) **Dynamic off-screen crt beam blanking circuit.**

(57) A circuit for blanking the electron beam of a cathode-ray tube (CRT) when the beam is horizontally deflected off-screen. Blanking is accomplished by comparing a horizontal drive signal to first and second reference voltages corresponding to the respective drive signals deflecting the electron beam to opposite edges of the CRT screen. The beam blanking circuit includes a differential amplifier receiving a ramp signal at its summing junction input. The differential amplifier drives a transistor connected in a high gain configuration to generate the horizontal drive signal at its collector. The horizontal drive signal is fed back through a summing resistor to the sum injunction of the differential amplifier to assure linear operation. A first comparator connected across the vase-collector junction of the transistor to blank the electron beam when the horizontal drive signal approaches saturation near one power supply voltage. A second comparator is connected between the collector and ground to blank the electron beam when the horizontal drive signal approaches ground potential. The horizontal drive signal thus deflects the electron beam to opposite edges of the CRT screen when the drive voltage varies between ground and the power supply voltage.

1

## Description

## DYNAMIC OFF-SCREEN CRT BEAM BLANKING CIRCUIT

### Technical Field

The present invention relates generally to an electron beam control for a cathode-ray tube, such as used in oscilloscopes, waveform monitors and vector scopes and, more particularly, a control for blanking the electron beam when it reaches either horizontal extreme of the screen of the cathode-ray tube.

### Background Art

Cathode ray tube (CRT) displays utilize a beam of electrons which generally sweep horizontally across the face of the tube during a sweep gate signal. At the same time, the beam deflects vertically in proportion to the magnitude of an applied voltage. The face of the CRT is illuminated at the point where it is struck by the beam, thereby writing a waveform on the face of the CRT. After the electron beam of a cathode-ray tube (CRT) is swept across the screen to display a waveform, the beam will typically continue to operate or write for a period since the sweep gate signal continues after the beam goes off-screen. At the end of the sweep gate signal, a blanking circuit is triggered which blanks the electron beam until a retrace circuit positions the beam off-screen at the other horizontal extreme of the screen. The beam writes off-screen in this position until a sync signal activates the sweep gate and initiates another sweep of the beam across the screen.

With such conventional beam controls, the beam can spend a significant time writing off-screen at both horizontal extremes of the screen. The time the beam is off-screen is also increased to the extent the operator adjusts a

2

horizontal position control to shift the beam toward either horizontal extreme of the screen. As a result of such off-screen writing of the beam, the average beam current of the CRT is needlessly increased, thus decreasing the functioning life of the CRT. Furthermore, the off-screen writing reduces the contrast of the display and thereby degrades the quality of the waveform traced out on the screen. Contrast degradation results because the electron beam writing off-screen generates diffused electrons which find their way onto the screen to cause a halo or glowing effect and increase lighting of the entire screen, all of which reduces the contrast. Secondary emissions also occur which reduce the contrast as a result of electrons from the beam bouncing off their off-screen target and being attracted to the screen.

When the contrast is so reduced, the operator of the device which incorporates the CRT often tries to compensate for the loss by increasing the beam brightness or intensity control. While this increases the intensity of the beam, it also increases the amount of diffused electrons and secondary emissions from the beam when it is off-screen, the very cause of the reduction of contrast. The improvement in contrast from increasing the beam brightness may thereby be negated, or at least minimized, and the use of a more intense beam decreases the life of the CRT.

The problem is particularly severe in devices like television waveform monitors and color phase angle vector scopes which use horizontal magnifiers. Horizontal magnifiers increase the speed at which the beam sweeps across the screen of the CRT thereby reducing the percentage of time during the sweep gate signal that the beam is on screen. The use of a horizontal magnifier degrades contrast in two respects. First, increased Z axis drive voltages are necessary to produce an adequate trace at the higher writing rates inherent in horizontal magnification. By increasing the drive voltage, however, the off-screen beam current is also intensified, thereby increasing the amount of diffused electrons and secondary emissions and reducing the useful life of the tube. Second, horizontal magnification increases the time that the beam spends writing off-screen, thereby also ~~increasing diffused electrons~~ increasing the average secondary and diffusion emissions, increasing the background glow, and reducing contrast. When a particularu variety of CRT, known as mesh tube is used, the effect is especially troublesome. The same problems may occur in conventional oscilloscopes when the horizontal display is adjusted for magnification and the beam brightness is increased to compensate for the increased beam writing rate, since the beam writes off-screen for long periods before the sweep gate signal results in blanking of the beam.

A similar problem can occur as a result of the beam continuing to write after it goes off-screen, and is encountered in devices where the horizontal sweep control or deflection amplifier allows the beam to bounce or fold back onto the screen after it has once passed off-screen.

In summary, existing CRT drive circuits cause impaired contrast and reduced service life because the beam sweep signal which causes the beam to write is generated for a predetermined period each sweep cycle regardless of the position of the beam on the screen of the CRT.

Disclosure of the Invention

It is an object of the invention to provide a circuit for blanking the beam of an oscilloscope CRT whenever the beam is writing off-screen regardless of the writing speed or horizontal position setting of the oscilloscope.

It is another object of the invention to provide a horizontal drive circuit for an oscilloscope which is capable of magnifying a portion of a displayed waveform without degrading the contrast or reducing the useful life of the oscilloscope's CRT.

4

It is still another object of the invention to provide a cathode ray tube blanking circuit that is particularly suitable for mesh-type cathode-ray tubes in point horizontal magnifiers.

These and other objects of the invention are provided by a cathode-ray tube deflection circuit in which the deflection signal is compared to a pair of reference voltages corresponding to the opposite edges of the screen of the cathode-ray tube. When the deflection signal is outside of the range of the two reference signals, the Z-axis blanking circuit of the CRT is triggered, thereby preventing the beam from writing off the screen of the CRT. As a result, off- screen writing is prevented regardless of the beam position setting or the rate at which the beam writes across the screen of the CRT. While the inventive drive circuit may be used to blank the CRT in any direction, the circuit is particularly suitable as a horizontal blanking circuit for cathode-ray tubes used in oscilloscopes having a horizontal magnification circuit.

Brief Description of the Drawings

Fig. 1 is a block diagram of a conventional prior art horizontal drive circuit.

Fig. 2 is a timing diagram illustrating two of the signals present in the prior art circuit of Fig. 1 when operating in the unmagnified condition.

Fig. 3 is a timing diagram illustrating two of the signals present in the prior art circuit of Fig. 1 when operating in the magnified condition.

Fig. 4 is a block diagram of the inventive off-screen beam blanking circuit.

Best Mode for Carrying Out the Invention

Cathode-ray tubes (CRTs) used in oscilloscopes generate an electron beam that is directed onto the screen of the CRT at a location along the X and Y axes determined by respective X and Y axis drive signals. The Y axis signal is normally proportional to a signal of interest connected to the Y axis input of the oscilloscope. The X axis drive signal, on the other hand, is normally a linearly increasing signal, or "ramp" that causes the beam to move horizontally across the screen at a uniform rate. The ramp signal starts increasing at the start of an enabling or "sweep gate" signal and is reset to its original value at the end of the sweep gate signal. The sweep gate signal is normally used to control the "Z axis" or blanking of the cathode-ray tube in order to theoretically de-energize the electron beam when the beam is no longer directed onto the screen of the CRT.

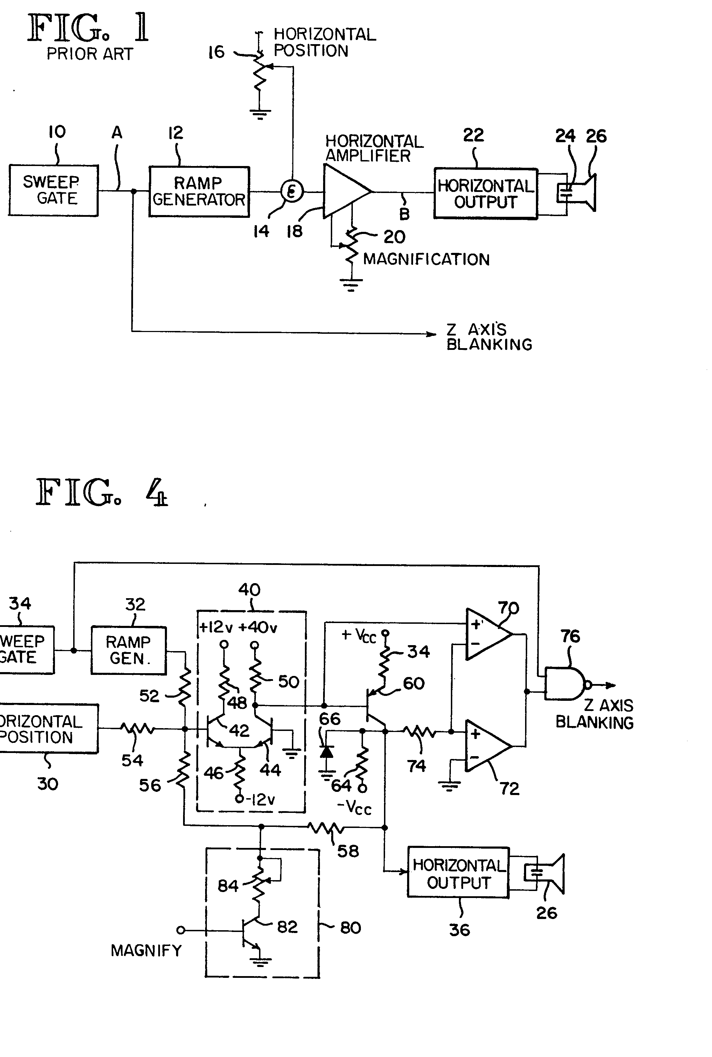

A typical prior horizontal drive circuit is illustrated in Fig. 1. A trigger signal is applied to a sweep gate circuit 10 which then generates a pulse having a predetermined duration. The pulse is applied to a conventional ramp generator circuit 12 which is normally an integrator. The ramp generator 12 thus generates a constantly increasing voltage during the entire period of the sweep gate pulse and it is reset to zero at the termination of the sweep gate pulse. The ramp from the ramp generator circuit 12 is then added to a horizontal position signal at summing junction 14. The horizontal position signal is normally controlled by a manually adjustable potentiometer 16. The output of the summing circuit 14 is thus a voltage that is proportional to the horizontal position of the electron beam on the screen of the CRT.

The output of the summing circuit 14 is applied to a horizontal amplifier 18 which includes a conventional magnification circuit controlled by the potentiometer 20. The effect of this magnification circuit on the horizontal output signal is described in greater detail hereinafter. The horizontal drive signal is then applied to a horizontal output circuit 22 of convention design which generates a differential signal applied between the horizontal deflection plates 24 of a conventional cathode-ray tube (CRT) 26. The sweep gate signal from the sweep gate generator 10 is also used to blank the CRT 26.

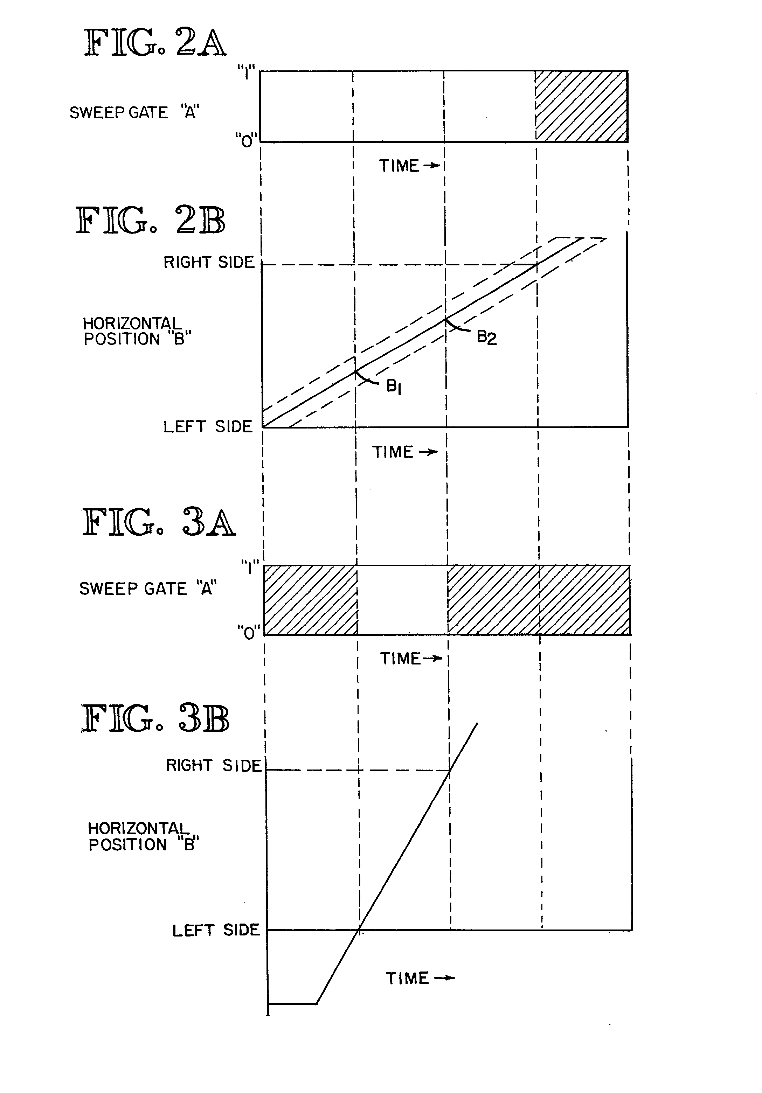

The sweep gate signal generated by the sweep gate 10 (signal "A") is illustrated in Fig. 2A, while the horizontal drive signal (signal "B") at the output of the horizontal amplifier 18 is illustrated in Fig. 2B. Note that the sweep gate signal has the same duration as the ramp signal. At the start of the sweep gate signal, the horizontal drive signal increases in voltage from a voltage which places the electron beam at the left side of the CRT screen. The horizontal drive voltage then linearly increases until it reaches a voltage which places the electron beam at the right side of the CRT. Thereafter, the horizontal drive voltage continues to increase until the horizontal amplifier 18 saturates. The horizontal drive signal is then reset at the termination of the sweep gate signal. Note that for the shaded portion of the sweep gate signal, the electron beam has already reached the right side of the CRT screen and remains there until the termination of the sweep gate signal. During this period, the electron beam generates diffused electrons and creates secondary emissions which reduce the contrast on the screen and the life of the CRT.

The portion of the sweep gate where the electron beam is "on screen" is also affected by adjustment of the horizontal position potentiometer 16. Adjustment of the horizontal position potentiometer 16 applies either a positive or negative off-set voltage to the horizontal drive signal so that the horizontal drive signal follows one of the dotted lines illustrated in Fig. 2B. A positive off-set voltage moves the electron beam toward the right of the screen thereby causing the beam to reach the right-most edge relatively early in the sweep gate. As a result, the electron beam is writing off-screen for a relatively longer period of time.

Many oscilloscopes have the capability of examining only a portion of a waveform, such as the portion occur-

ring between B1 and B2, as illustrated in Fig. 2B. This is done by horizontally magnifying the horizontal drive signal and applying an appropriate off-set to it so that the horizontal drive signal is at a voltage placing the electron beam at the left side of the screen at time B1 and the horizontal drive voltage is at a voltage placing the electron beam at the right side of the screen at the time B2. The drive voltage performing this function is illustrated in Fig. 3B. Note that the electron beam is on screen only during the unshaded portion of the sweep gate signal illustrated in Fig. 3A between time B1 and time B2. The electron beam is writing off-screen during the entire shaded portion of the sweep gate signal illustrated in Fig. 3A. Insofar as the electron beam is writing off screen for a substantially longer time than in the unmagnified condition illustrated in Fig. 2A, the degradation and contrast is correspondingly worse. Also, it is necessary to increase the intensity of the electron beam since the electron beam sweeps across the screen during the period B1 to B2 instead of the substantially longer sweep time illustrated in Fig. 2B. The increased intensity of the electron beam further degrades contrast and reduces the useful life of the CRT.

In both examples illustrated in Figs. 2 and 3, it should be noted that the Z-axis blanking circuit is actuated when the ramp generator is reset at the termination of the sweep gate signal. However, the problem results from the lack of any Z axis blanking from the start of the sweep gate signal to the time that the horizontal drive voltage reaches the left side deflection value and from the point where the horizontal deflection signal reaches the right side deflection value to the end of the sweep gate signal.

The inventive blanking circuit avoids the aforementioned problems of conventional blanking circuits by basically comparing the horizontal drive voltage to reference voltages corresponding to the left and right side deflection voltages and produces Z-axis blanking whenever the drive voltage is less than the left side deflection voltage or greater than the right side deflection voltage. The blanking circuit thus prevents any substantial off-screen writing of the electron beam.

The inventive blanking circuit, as illustrated in Fig. 4, utilizes a conventional horizontal position control circuit 30 and a conventional ramp generator 32 controlled by a conventional sweep gate circuit 34. The position control circuit 30, ramp generator 32 and sweep gate circuit 34, also are of well-known design in the art and are not described in detail herein. Also utilized are a conventional horizontal output circuit 36 of well-known design and not described in detail herein.

As mentioned above, the horizontal position control 30 produces a horizontal control biasing signal which shifts the writing of the beam toward either horizontal extreme of the CRT screen as desired by an operator. The ramp generator 32 produces a substantially linear ramp control signal. The horizontal output circuit 36 provides the beam deflection signals to the CRT, and includes the operator adjustment for writing the beam across the screen at a preselected rate.

The inventive blanking circuit includes a differential amplifier, indicated generally by reference numeral 40 which is formed by emitter coupled NPN transistors 42, 44, resistor 46 acting as a current sink and load resistors 48, 50. The base of transistor 42 is biased at zero volts by the base of transistor 44 being connected to ground the base of transistor 42 thus acts as a summing junction. The outputs of the ramp generator 32 and the horizontal position control 30 are applied to the summing junction through respective summing resistors 52, 54. Feedback current is also applied to the summing junction through feedback resistors 56, 58. The feedback voltage (i.e., the signal applied to the horizontal output circuit 36) is thus equal to the sum of the ramp signal (multiplied by a scale factor) and the horizontal position signal (multiplied by a scale factor). The differential amplifier 40 may also be of conventional operational amplifier design, preferably with low input and output impedances. The output of the differential amplifier 40 is connected to the base of a high gain amplifying PNP transistor 60. The collector of the transistor 60 is connected through feedback resistors 56, 58 to the summing junction of the differential amplifier 40 to provide a negative feedback loop to the amplifer. The collector of the transistor 60 is also connected to the horizontal output circuit 36 and to Z-axis blanking circuits described below. As a result of the negative feedback loop, large voltage variations on the base of transistor 42 (the input of the differential amplifier 40) results in small, substantially linear, inverted voltage swings on the collector of transistor 60. The differential amplifier 40 is biased so that the transistor 60 is driven linearly between a saturated condition and an off condition over the operating range of the differential amplifier 60.

The emitter of the transistor 60 is connected through a resistor 62 to a positive power supply voltage +VCC, and the collector is connected through a relatively larger value resistor 64 to a negative power supply voltage -- VCC. The cathode of a clamping diode 66 is connected to the collector of the transistor 60 and its anode is connected to ground. In operation, as the output signal of the differential amplifier 40 decreases and drives the transistor 40 toward the saturation condition, the voltage on the collector of the transistor approaches the +VCC voltage level. As the output signal of the differential amplifier 40 increases and drives the transistor 60 toward the cut-off condition, the collector of transistor 60 is driven toward -VCC until diode 66 becomes forward biased. Diode 66 then clamps the collector of transistor 60 at $-V_D$, or about -0.7 volts. The output range of the transistor 60 is thus between about -0.7 and +VCC.

The Z-axis blanking circuit referred to above includes a first comparator 70, and a second comparator 72, of a well-known and conventional design which will not be described in detail herein. The negative input of the first comparator 70 and the positive input of the second comparator 72 are connected together and through a resistor 74 to the collector of the transistor 60. The positive input of the first comparator 70 is connected to the base of the transistor 60. The negative input of the second comparator 72 is connected to ground. The outputs of the first and second comparators 70 and 72 are connected together and to the input of NAND-gate 76.

With such an arrangement, the first comparator 70 is high until the output signal of the differential amplifier 40 drives the transistor 60 sufficiently toward the saturation condition (i.e., where the transistor's collector voltage approaches the positive power supply voltage +VCC), that the collector voltage exceeds the output signal of the differential amplifier 40. At such time, the output of the first comparator 70 goes low, thereby causing the X-axis blanking signal at the output of NAND-gate 76 to be high. The threshold level at which the first comparator 70 changes states is established to correspond to a voltage between the outputs of the horizontal output circuit 36 which causes deflection of the election beam to the right-most horizontal edge of the CRT screen.

The output of the second comparator 72 is high until the output of the differential amplifier 40 drives the collector of transistor 60 sufficiently toward the cut-off condition that the collector voltage falls below the ground level. At such time, the output of the second comparator 72 goes low thereby causing the Z-axis blanking signal at the output of NAND-gate 76 to be high. The threshold level at which the second comparator 72 changes state is established to correspond to a voltage between the outputs of the horizontal output circuit 36 which causes deflection of the electron beam to the left-most horizontal edge of the CRT screen.

Since the outputs of the first and second comparators 70 and 72 are connected together, the Z-axis blanking signal is applied by the NAND-gate 76 to the blanking circuits whenever the output of either of the comparators 70, 72 is low. Conversely, no Z-axis blanking signal is generated if both outputs of the comparators 70 and 72 are high. As previously described, the outputs of the first and second comparators 70 and 72 are low whenever the collector voltage of the transistor 60 is outside the threshold levels corresponding to horizontal drive signal values which drive the beam to one or the other of the horizontal edges of the CRT screen. By so making the operation of the off-screen blanking circuit dependent on the drive signal controlling the positioning of the electron beam, blanking occurs whenever the beam reaches one of the horizontal extremes of the screen. Blanking is thus affected by adjustments to the horizontal position control 30 for shifting the beam left or right on the screen or altering of the horizontal drive signal to increase the writing rate across the screen for achieving horizontal magnification of a traced waveform. However, Z-axis blanking is also accomplished in the traditional manner by applying the sweep gate signal to NAND-gate 76. Among other functions, this prevents the beam from writing on the CRT screen during retrace of the election beam.

The gain of the differential amplifier 40 may be adjusted to increase the horizontal sweep speed in order to magnify a portion of the displayed waveform. The gain of the differential amplifier is increased by shunting a portion of the feedback signal through a conventional magnifying circuit 80 which may include a shunting transistor 82. When transistor 82 is turned on by a high MAGNIFY signal, potentiometer 84 is effectively connected to ground. The resistance of the potentiometer 84 is manually adjustable in order to control the gain of the differential amplifier 40 and hence the horizontal sweep rate. The position control 30 selects the portion of the waveform to be amplified. The magnifying circuit 80 is of conventional design and thus only a portion of this circuit is illustrated.

It will be appreciated that, although a specific embodiment of the present invention has been described herein for purposes of illustration, various modifications may be made without departing from the spirit and scope of the invention. Accordingly, the invention is not limited except as by the appended claims.

Claims

We claim:

1. An electron beam blanking circuit for a cathode-ray tube, comprising:

means for generating an electron beam drive signal for deflecting an electron beam across a screen of the cathode-ray tube;

reference means for establishing a limit corresponding to a beam drive signal value deflecting said beam to one edge of the screen;

comparator means for comparing said beam drive signal to said limit; and

means responsive to said comparator means for blanking said electron beam if said comparator means indicates said beam has been driven to said one edge of the screen by said beam drive signal.

2. An electron beam blanking circuit for a cathode-ray tube, comprising:

means for generating an electron beam drive signal for deflecting an electron beam across a screen of the cathode-ray tube;

first reference means for establishing a first limit corresponding to a beam drive signal value deflecting said beam to one edge of the screen;

second reference means for establishing a second limit corresponding to a beam drive signal value deflecting said beam to an opposite edge of the screen;

first comparator means for comparing said beam drive signal to said first limit and generating a first limit comparison signal if said beam has been deflected by said beam drive signal beyond said one edge of the screen; and

second comparator means for comparing said beam drive signal to said second limit and generating a second limit comparison signal if said beam has been deflected by said beam drive signal beyond said opposite edge of the screen;

14

means responsive to said first and second limit comparison signals for blanking said electron beam such that said beam is blanked if said beam has been deflected beyond either edge of the screen by said beam drive signal.

3.    The electron beam blanking circuit of claim 2 wherein said electron beam drive signal is a signal that linearly increases with time and is connected to said cathode-ray tube in a manner that causes said electron beam to scan horizontally across the screen of said cathode-ray tube in accordance with said drive signal.

4.    An electron beam blanking circuit for a cathode-ray tube, comprising:

a ramp generator for generating a linearly increasing electron beam drive signal for deflecting an electron beam across a screen of the cathode-ray tube;

a reference generator for establishing a reference threshold corresponding to a beam drive signal value deflecting said beam to one edge of the screen;

a comparator for comparing said beam drive signal to said reference threshold and generating a threshold comparison signal indicating said beam has been deflected to said one edge of the screen by said beam drive signal; and

an electron beam blanking circuit responsive to said threshold comparison signal for blanking said electron beam if said comparison signal indicates said beam drive signal has crossed said reference threshold.

5.    The electron beam blanking circuit of claim 4, further including means for selectively adjusting the rate of increase of said beam drive signal to provide a plurality of beam writing rates across the screen.

6.    An electron beam blanking circuit for a cathode-ray tube, comprising:

a ramp generator for generating a linearly increasing electron beam drive signal for deflecting an electron beam across a screen of the cathode-ray tube;

a first reference generator for establishing a lower reference threshold corresponding to a beam drive signal value deflecting said beam to one edge of the screen;

a second reference generator for establishing an upper reference threshold corresponding to a beam drive signal value deflecting said beam to an opposite edge of the screen;

a first comparator for comparing said beam drive signal to said lower reference threshold and generating a lower threshold comparison signal indicating said beam has been deflected to said opposite edge of the screen by said beam drive signal;

a second comparator for comparing said beam drive signal to said upper reference threshold and generating an upper threshold comparison signal indicating said beam has been driven to said opposite horizontal extreme of the screen by said beam drive signal; and

an electron beam blanking circuit responsive to said lower and upper threshold comparison signals for blanking said electron beam if said lower comparison signal indicates said beam drive signal has crossed said lower reference threshold or if said upper comparison signal indicates said beam drive signal has crossed said upper reference threshold.

7. The electron beam blanking circuit of claim 6, further including means for selectively adjusting the rate of increse of said beam drive signal to provide a plurality of beam writing rates.

8. An electron beam blanking circuit for a cathode-ray tube, comprising:

a signal generator for generating a substantially linear drive signal;

a differential amplifier receiving said drive signal for generating an output signal in direct inverse proportion thereto;

a high gain amplifier driven by the output of said differential amplifier for generating a beam deflection signal, said output signal providing negative feedback to the input of said differential amplifier;

a sweep driver circuit deflecting an electron beam across a screen of the cathode-ray tube, said sweep driver being responsive to said beam deflection signal;

a first comparator for comparing said beam deflection signal to a first preselected voltage and generating a first limit comparison signal that changes state when said beam deflection signal is equal to said first preselected voltage, said preselected voltage corresponding to a beam deflection first signal positioning said beam to one edge of the screen;

a second comparator for comparing said beam deflection signal to a second preselected voltage and generating a second limit comparison signal that changes state when said beam deflection signal is equal to said second preselected voltage, said second preselected voltage corresponding to a beam deflection signal positioning said beam to an opposite edge of the screen; and

an electron beam blanking circuit responsive to said first and second limit comparison signals for blanking said electron beam if said beam has been driven beyond either edge of the screen.

9. The electron beam blanking circuit of claim 8 wherein said high gain amplifier is a transistor biased for substantially linear operation over a range of output signals extending between said first and second preselected voltages, said transistor approaching a saturated conducting state as said high gain amplifier output signal approaches one of said preselected voltages.

10. The electron beam blanking circuit of claim 8 wherein said differential amplifier has a summing junction non-inverting input to which said drive signal is applied through a summing resistor, and wherein said high gain amplifier is a transistor having its base connected to the output of said signal generator to receive said drive signal, its emitter connected to a supply voltage of one polarity and its collector connected through a resistor to a supply voltage of another polarity and to the non-inverting input of said differential amplifier through a respective summing resistor in order to provide said negative feedback, said beam deflection signal being generated at the collector of said transistor.

11. The electron beam blanking circuit of claim 10 wherein said first comparator is connected between the base and collector of said transistor and said second comparator is connected between the collector of said transistor and a predetermined voltage in parallel with a clamping diode.

12. A method of blanking an electron beam of a cathode-ray tube, comprising:
generating an electron beam drive signal for deflecting an electron beam across a screen of the cathode-ray tube;
establishing a limit corresponding to a beam drive signal value deflecting said beam to one edge of the screen;
comparing said beam drive signal to said limit; and
blanking said electron beam if said comparison of said beam drive signal to said limit indicates said beam has been deflected to said one edge of the screen by said beam drive signal.

13. The method of claim 12, further including:
establishing a second limit corresponding to a beam drive signal value deflecting said beam to an opposite edge of the screen;
comparing said beam drive signal to said second limit; and
blanking said electron beam if said comparison of said beam drive signal to said second limit indicates said beam has been deflected to said opposite edge of the screen by said beam drive signal.

FIG. 1
PRIOR ART

FIG. 4

2/2

0138399

FIG. 2A

SWEEP GATE "A"

TIME →

FIG. 2B

RIGHT SIDE

HORIZONTAL POSITION "B"

B₂

B₁

LEFT SIDE

TIME →

FIG. 3A

SWEEP GATE "A"

TIME →

FIG. 3B

RIGHT SIDE

HORIZONTAL POSITION "B"

LEFT SIDE

TIME →

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-A-1 025 980  (PHILIPS)<br>* claims 1 and 2 * | 1,12 | G 01 R   13/26 |
| A | | 2,4,6,<br>8 | |
| | ----- | | |
| | | | |

**TECHNICAL FIELDS SEARCHED (Int. Cl.4)**

G 01 R

The present search report has been drawn up for all claims

| Place of search | Date of completion of the search | Examiner |
|---|---|---|
| THE HAGUE | 11-12-1984 | MIELKE W |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO Form 1503 03.82